# EUROPEAN PATENT APPLICATION

(11) **EP 4 818 258 A1**
(43) Date of publication of application: **07.10.2026**
(21) Application number: 24910623.8
(22) Date of filing: 05.12.2024
(51) Int. Cl.: C08L 65/00, C08L 45/00, C08L 23/00, C08L 23/16, C08L 51/06, C08K 3/24, C08K 3/22, C08K 3/00, H01B 3/12, H01B 3/44, H05K 1/03

(54) **RESIN COMPOSITION, AND PREPARATION METHOD THEREFOR AND USE THEREOF**

(30) Priority: 26.12.2023 CN 202311816485
(71) Applicant: Huawei Technologies Co., Ltd., Shenzhen, Guangdong 518129 (CN)
(72) Inventor: DUAN, Qiongjuan, Shenzhen, Guangdong 518129 (CN); CHEN, Hongyu, Shenzhen, Guangdong 518129 (CN); LIU, Xinming, Shenzhen, Guangdong 518129 (CN); LIAO, Zhiqiang, Shenzhen, Guangdong 518129 (CN)
(74) Representative: Goddar, Heinz J.
(86) International application number: PCT/CN2024/137237
(87) International publication number: WO 2025/139691

(57) **Abstract**

Embodiments of this application provide a resin composition, a preparation method therefor, and use thereof. The resin composition includes the following components in mass percentages: 30% to 60% of cyclic olefin-based polymer, 3% to 15% of polyolefin and/or modified polyolefin, and 35% to 70% of filler. The filler includes a titanate filler and a non-titanate filler. A mass percentage of the titanate filler ranges from 10% to 40%, a mass percentage of the non-titanate filler ranges from 0% to 40%, and a dielectric constant of the non-titanate filler is greater than 20. The resin composition according to embodiments of this application has a high dielectric constant, a low dissipation factor, and excellent heat resistance and impact resistance. When used as a dielectric material in the communication field, the resin composition can improve signal transmission efficiency while satisfying requirements for mechanical properties and heat resistance.

## Description

This application claims priority to Chinese Patent Application No. 202311816485.7, filed with the China National Intellectual Property Administration on December 26, 2023 and entitled "RESIN COMPOSITION, PREPARATION METHOD THEREFOR, AND USE THEREOF", which is incorporated herein by reference in its entirety.

### TECHNICAL FIELD

Embodiments of this application relate to the field of communication technologies, and in particular, to a resin composition, a preparation method therefor, and use thereof.

### BACKGROUND

With the development of communication technologies, there is an ever-increasing demand for high-energy-efficiency high-frequency communication. In high-frequency communication scenarios, dielectric materials with an extremely low dissipation factor Df are required to minimize signal transmission loss. In addition, in the case of microcapacitors with volume constraints, to develop high-power capacitor elements with a high safety factor, it is necessary to use dielectric materials with a higher dielectric constant Dk and a lower dissipation factor Df.

However, conventional high-dielectric ceramic materials suffer from high production costs, poor toughness, and poor processability. Moreover, among thermoplastic composite materials with a high dielectric constant and a low dissipation factor that have attracted significant attention, polyphenylene ether composites are most widely used. Such materials exhibit a dissipation factor of 0.0015 to 0.003 at a high frequency above 10 GHz, but still fail to meet stringent requirements of ultra-high energy efficiency antennas. In addition, higher requirements have now been imposed on the properties of dielectric materials, including heat resistance and mechanical strength. For example, when telephone traffic or data transmission is active, an antenna radio frequency module operates at high-power conditions, resulting in excessive heat generation within the module. This in turn requires the dielectric materials to have a high heat deflection temperature.

Therefore, to better meet application requirements of high-frequency communication and miniaturized electronic components, it is necessary to provide a resin composition that has a high dielectric constant, a low dissipation factor, and excellent heat resistance and impact resistance.

### SUMMARY

In view of this, embodiments of this application provide a resin composition. The resin composition has a high dielectric constant, a low dissipation factor, and excellent heat resistance and impact resistance. When used as a dielectric material in the communication field, the resin composition can improve signal transmission efficiency and satisfy requirements for mechanical properties and heat resistance, thereby better meeting application requirements of high-frequency communication and miniaturized communication components.

A first aspect of embodiments of this application provides a resin composition. The resin composition includes the following components in mass percentages: 30% to 60% of cyclic olefin-based polymer, 3% to 15% of polyolefin and/or modified polyolefin, and 35% to 70% of filler.

The filler includes a titanate filler and a non-titanate filler. A mass percentage of the titanate filler ranges from 10% to 40%, a mass percentage of the non-titanate filler ranges from 0% to 40%, and a dielectric constant of the non-titanate filler is greater than 20.

The resin composition according to embodiments of this application is obtained by compounding a cyclic olefin-based polymer with a polyolefin and/or a modified polyolefin, as well as a specific type of filler. The resin composition may have a high dielectric constant, a low dissipation factor, and excellent heat resistance and impact resistance. When used as a dielectric material in the communication field, the resin composition can improve signal transmission efficiency, and satisfy requirements for mechanical properties and heat resistance, thereby better meeting application requirements of high-frequency communication and miniaturized communication components, and promoting development of high-frequency operation and miniaturization of communication components such as an antenna.

The cyclic olefin-based polymer has excellent dielectric properties, heat resistance, processability, and the like. When used as the base resin of a dielectric material in the communication field, the cyclic olefin-based polymer enables the dielectric material to better meet application requirements in the communication field. There are two types of cyclic olefin-based polymer: a cyclic olefin copolymer (Cyclic Olefin Copolymer, COC) and a cyclic olefin polymer (Cyclic Olefin Polymer, COP). The cyclic olefin copolymer (Cyclic Olefin Copolymer, COC) is obtained by copolymerizing ethylene or an α-olefin (referring to a monoolefin having a double bond at a terminal of a molecular chain) with a cyclic olefin monomer such as a norbornene-based monomer. The cyclic olefin polymer (Cyclic Olefin Polymer, COP) is obtained by homopolymerizing a cyclic olefin monomer such as a norbornene-based monomer.

In an implementation of this application, a heat deflection temperature of at least a portion of the cyclic olefin-based polymers is greater than or equal to 140°C. The cyclic olefin-based polymers have a high heat deflection temperature, which is helpful to improve the heat resistance of the resin composition.

In an implementation of this application, a heat deflection temperature of at least a portion of the cyclic olefin-based polymers is greater than or equal to 150°C.

In an implementation of this application, a heat deflection temperature of at least a portion of the cyclic olefin-based polymers is greater than or equal to 160°C.

In an implementation of this application, at least a portion of the cyclic olefin-based polymers are cyclic olefin copolymers. The presence of the cyclic olefin copolymer helps improve the heat resistance of the resin composition.

In an implementation of this application, the mass percentage of the polyolefin and/or the mass percentage of the modified polyolefin range/ranges from 5% to 10%. Incorporation of an appropriate amount of the polyolefin and/or the modified polyolefin can effectively improve toughness of the resin composition, enhance impact and damage resistance of the resin composition, improve interfacial bonding strength between inorganic and organic fillers, and enable sufficient incorporation of the cyclic olefin-based polymer and the filler into the resin composition, thereby helping ensure the heat resistance, dielectric properties, and other mechanical properties of the resin composition.

In some implementations of this application, the mass percentage of the polyolefin in the resin composition ranges from 5% to 15%. A primary function of the polyolefin is to improve the toughness of the resin composition and enhance the impact resistance. Controlling the content of the polyolefin at a high level helps further enhance the impact resistance of the resin composition.

In some implementations of this application, the mass percentage of the modified polyolefin in the resin composition ranges from 1% to 5%. The primary function of the modified polyolefin is to improve the interfacial bonding strength between the components. Controlling the content of the modified polyolefin at a low level helps improve the interfacial bonding strength and ensure enhancement of the impact resistance.

In an implementation of this application, a melting temperature of the polyolefin and/or a melting temperature of the modified polyolefin are/is greater than 105°C. The melting temperature is defined as a temperature required for a substance to transition from a high elastic state to a viscous flow state. The polyolefin and the modified polyolefin have a high melting temperature, which helps ensure that the resin composition still maintains high heat resistance while the polyolefin and the modified polyolefin improve the toughness of the resin composition.

In implementations of this application, the polyolefin includes a polyolefin block copolymer. The polyolefin block copolymer is a polymer obtained by block copolymerization of two or more olefin monomers, and has two or more different olefin monomer units arranged in an orderly manner. The block copolymerization manner of the polyolefin block copolymer can ensure high heat resistance and maintain toughness of the material. The polyolefin block copolymer may be, for example, a propylene-butadiene block copolymer, an ethylene-propylene block copolymer, an ethylene-butadiene block copolymer, or the like.

In implementations of this application, the modified polyolefin includes a maleic anhydride-grafted polyolefin.

In an implementation of this application, a mass ratio of the titanate filler to the non-titanate filler is greater than or equal to 0.5:1. Controlling the mass ratio helps improve the dielectric properties of the resin composition and better ensures dimensional stability of the molded article of the resin composition.

In implementations of this application, the titanate filler includes one or more of calcium titanate, calcium magnesium titanate, calcium strontium titanate, barium strontium titanate and barium titanate. The titanate filler has a high dielectric constant, can improve mechanical properties, and exhibit good compatibility with a resin component. Incorporation of the titanate filler into the resin composition helps improve dielectric properties and impact resistance of the resin composition.

In an implementation of this application, the titanate filler is in a form of spherical or subspherical particles, with an average sphericity of greater than 0.85. The titanate filler being in the form of spherical or subspherical particles helps better reduce a dissipation factor Df of the resin composition, minimize interface defects, improve mechanical properties of the resin composition, increase a melt flow index of the composition, and facilitate injection molding processing. A higher sphericity is more advantageous. The sphericity is a parameter characterizing particle morphology, defined as the ratio of the surface area of a sphere having the same volume as a particle to the surface area of the particle. A particle that is morphologically closer to a sphere has a sphericity closer to 1.

In an implementation of this application, a D50 particle size of the titanate filler ranges from 0.5 µm to 100 µm. D50 refers to a particle size at which a cumulative particle size distribution percentage of a sample reaches 50%, and D50 is also referred to as a median diameter or a median particle size. The titanate filler having an appropriate particle size facilitates uniform dispersion of the titanate filler in the resin composition, better exerts performance advantages of the titanate filler, and improves compactness, dielectric properties, mechanical properties, and the like of a molded article obtained by molding the resin composition.

In implementations of this application, the non-titanate filler includes a metal or a non-metal oxide, and the metal oxide or the non-metal oxide includes hafnium dioxide, titanium oxide, lead oxide, tantalum oxide, or the like. The metal oxides each have a high dielectric constant and structural stability. When the metal oxide is compounded with the titanate filler and incorporated into the resin composition, the dielectric properties and dimensional stability of the resin composition can be effectively improved.

In some implementations of this application, a dielectric constant of the non-titanate filler is greater than 50. Selection of a non-titanate filler having a high dielectric constant helps improve the dielectric properties of the resin composition.

In an implementation of this application, the non-titanate filler is in a form of spherical or subspherical particles, with an average sphericity of greater than 0.85. The non-titanate filler being in the form of spherical or subspherical particles helps better reduce a dissipation factor Df of the resin composition, minimize interface defects, and improve mechanical properties of the resin composition.

In an implementation of this application, a D50 particle size of the non-titanate filler ranges from 0.1 µm to 10 µm. The non-titanate filler having an appropriate particle size facilitates uniform dispersion of the titanate filler in the resin composition, better exerts the performance advantages of the non-titanate filler, and improves the compactness, dielectric properties, mechanical properties, and the like of the molded article obtained by molding the resin composition.

In an implementation of this application, a mass percentage of the non-titanate filler ranges from 20% to 35%. Incorporation of an appropriate amount of the non-titanate filler into the resin composition can better exert a synergistic effect with the titanate filler, enabling the resin composition to improve dielectric properties and reduce the influence of temperature drift, and further reduce the coefficient of thermal expansion of the resin composition, thereby enabling the resin composition to better combine excellent dielectric properties with a low coefficient of thermal expansion.

In an implementation of this application, the resin composition further includes an additive, and a mass percentage of the additive is less than or equal to 2%. The additive may be added according to practical requirements to improve relevant properties of the resin composition.

In implementations of this application, the additives include one or more of an antioxidant, a flame retardant, and a lubricant. The antioxidant can improve oxidation resistance of the resin composition, the flame retardant can improve flame retardancy of the resin composition, and the lubricant can improve lubricity of the resin composition.

In an implementation of this application, the dielectric constant Dk of the resin composition is greater than or equal to 4.5, and the dissipation factor Df at 10 GHz ranges from 0.0004 to 0.001. In embodiments of this application, the specific component design enables the resin composition to have a high dielectric constant and an extremely low dissipation factor at a high frequency of 10 GHz. When the resin composition is applied in the manufacture of communication components, signal transmission efficiency can be effectively improved, and loss can be reduced, thereby better meeting the requirements for high-quality and high-efficiency signal transmission at high frequencies and the demand for miniaturization of the communication components. The dielectric constant and the dissipation factor are measured by using a network analyzer equipped with a 10 GHz fixture.

In an implementation of this application, a heat deflection temperature of the resin composition is greater than or equal to 155°C. The heat deflection temperature (Heat deflection temperature, HDT) refers to a temperature at which a resin material undergoes deformation under an external load, and the heat deflection temperature is an important indicator for evaluating the heat resistance of the resin composition. The resin composition according to this embodiment of this application has a high heat deflection temperature, indicating that the resin composition has excellent heat resistance, can better meet requirements in high-temperature application scenarios, and improve service reliability of the communication component. The heat deflection temperature can be tested by using an HDT/Vicat tester according to a standard ISO 75-1: Plastics-Determination of temperature of deflection under load.

In an implementation of this application, an Izod notched impact strength of the resin composition is greater than 5 kJ/m². The Izod notched impact strength represents a capability of a material to resist impact, and may be tested by using the Izod notched impact tester according to a standard ISO 180: Plastics-Determination of Izod impact strength.

A second aspect of embodiments of this application provides a preparation method for the resin composition according to the first aspect, including:
mixing the components of the resin composition to obtain a mixture; and
melting the mixture, and then performing extrusion and pelletization, to obtain the resin composition.

The preparation method according to this embodiment of this application has a simple process, which facilitates mass production.

A third aspect of embodiments of this application provides a molded article, including the molded article of the resin composition according to the first aspect. The molded article may be designed into various regular or irregular shapes and specific dimensions according to practical application requirements. The molded article is in a solid state. Specifically, the molded article may be obtained by injection molding, calendering, or extrusion molding.

A fourth aspect of embodiments of this application provides an electronic component, where the electronic component includes the molded article of the resin composition according to the first aspect. The electronic component may be any electronic component requiring the application of a dielectric material, for example, a communication component, a capacitor, or the like.

In implementations of this application, the electronic component includes a communication component. The communication component employs the resin composition according to embodiments of this application as a dielectric material, and the resin composition may effectively enhance signal transmission efficiency, and also helps improve thermal stability and impact resistance, thereby enhancing product reliability.

In implementations of this application, the communication component includes an antenna, a microwave device, a radio frequency device, a metal stripline assembly, and the like. The molded article of the resin composition may be specifically used as a dielectric substrate or a dielectric frame.

In some embodiments, the resin composition is used in a microwave device in an antenna, and may be used, for example, in a phase control apparatus of the microwave device. The microwave device may be a microwave modulator, a microwave amplifier, a microwave filter, a microwave switch, a microwave mixer, or the like.

In some embodiments, the resin composition is used in a metal stripline assembly, and may be used, for example, to form an isolation apparatus between metal striplines.

In some embodiments, the resin composition is used in a radio frequency device. The radio frequency device may be a radio frequency amplifier, a radio frequency switch, a radio frequency filter, a radio frequency mixer, a radio frequency power amplifier, a combiner, a phase shifter, or the like.

Embodiments of this application further provide a communication system. The communication system includes a communication component, and the communication component includes a molded article of the resin composition according to the first aspect. The communication system using the foregoing communication component exhibits enhanced signal transmission efficiency, and better thermal stability and impact resistance.

### BRIEF DESCRIPTION OF DRAWINGS

FIG. 1 is a flowchart of a preparation method for a resin composition according to an embodiment of this application; and
FIG. 2 is a diagram of a structure of an electronic component 100 according to an embodiment of this application.

### DESCRIPTION OF EMBODIMENTS

The following describes embodiments of this application with reference to accompanying drawings in embodiments of this application.

Currently, dielectric materials applied to the communication industry fail to have a low dissipation factor at high frequencies, a high heat deflection temperature, and high impact resistance, which hinders development of high-frequency operation and miniaturization of communication components such as an antenna. In order to better meet application requirements of the communication components such as high-frequency and miniaturized components, an embodiment of this application provides a resin composition that has a high dielectric constant, a low dissipation factor, and high heat resistance and impact resistance.

The resin composition provided in this embodiment of this application includes the following components in mass percentages: 30% to 60% of cyclic olefin-based polymer, 3% to 15% of polyolefin and/or modified polyolefin, and 35% to 70% of filler.

The filler includes a titanate filler and a non-titanate filler. A mass percentage of the titanate filler ranges from 10% to 40%, a mass percentage of the non-titanate filler ranges from 0% to 40%, and a dielectric constant of the non-titanate filler is greater than 20.

The resin composition according to embodiments of this application is obtained by compounding a cyclic olefin-based polymer with a polyolefin and/or a modified polyolefin, as well as a specific type of filler. The resin composition may have a high dielectric constant, a low dissipation factor, and excellent heat resistance and impact resistance. When used as a dielectric material in the communication field, the resin composition can improve signal transmission efficiency, and satisfy requirements for mechanical properties and heat resistance, thereby better meeting application requirements of high-frequency communication and miniaturized communication components, and promoting development of high-frequency operation and miniaturization of communication components such as an antenna.

The cyclic olefin-based polymer has excellent dielectric properties, heat resistance, processability, and the like. When used as the base resin of a dielectric material in the communication field, the cyclic olefin-based polymer enables the dielectric material to better meet application requirements in the communication field. There are two types of cyclic olefin-based polymer: a cyclic olefin copolymer (Cyclic Olefin Copolymer, COC) and a cyclic olefin polymer (Cyclic Olefin Polymer, COP). The cyclic olefin copolymer (Cyclic Olefin Copolymer, COC) is obtained by copolymerizing ethylene or an α-olefin (referring to a monoolefin having a double bond at a terminal of a molecular chain) with a cyclic olefin monomer such as a norbornene-based monomer. The cyclic olefin polymer (Cyclic Olefin Polymer, COP) is obtained by homopolymerizing a cyclic olefin monomer such as a norbornene-based monomer.

In implementations of this application, to enable the resin composition to have higher heat resistance, at least a portion of the cyclic olefin-based polymer in the resin composition have a heat deflection temperature greater than or equal to 140°C. In other words, a portion or all of the cyclic olefin-based polymer has a heat deflection temperature greater than or equal to 140°C. The at least a portion may be at least 50%. That is, at least 50% of the cyclic olefin-based polymer has a heat deflection temperature greater than or equal to 140°C. In some embodiments, the at least a portion may be specifically, for example, 50%, 55%, 60%, 70%, 80%, 90%, 95%, or 100%.

In some implementations, at least a portion of the cyclic olefin-based polymer in the resin composition has a heat deflection temperature greater than or equal to 150°C. In other words, a portion or all of the cyclic olefin-based polymer has a heat deflection temperature greater than or equal to 150°C. The at least a portion may be at least 50%. That is, at least 50% of the cyclic olefin-based polymer has a heat deflection temperature greater than or equal to 150°C. In some embodiments, the at least a portion may be specifically, for example, 50%, 55%, 60%, 70%, 80%, 90%, 95%, or 100%.

In some implementations, at least a portion of the cyclic olefin-based polymer in the resin composition has a heat deflection temperature greater than or equal to 160°C. In other words, a portion or all of the cyclic olefin-based polymer has a heat deflection temperature greater than or equal to 160°C. The at least a portion may be at least 10%. That is, at least 10% of the cyclic olefin-based polymer has a heat deflection temperature greater than or equal to 160°C. In some embodiments, the at least a portion may be specifically, for example, 10%, 20%, 30%, 40%, 50%, 55%, 60%, 70%, 80%, 90%, 95%, or 100%.

In this application, a cyclic olefin-based polymer having a specific heat deflection temperature may be selected according to practical application requirements. The resin composition may include one type of cyclic olefin-based polymer, or may include a plurality of types of cyclic olefin-based polymers. The cyclic olefin-based polymer in the resin composition may have the same heat deflection temperature, or may have different heat deflection temperatures. In some embodiments, the resin composition includes a plurality of types of cyclic olefin-based polymers having different heat deflection temperatures.

In implementations of this application, at least a portion of the cyclic olefin-based polymer is a cyclic olefin copolymer. The cyclic olefin-based polymer in the resin composition may all be the cyclic olefin copolymer (COC), or may have a portion being the cyclic olefin copolymer (COC) and a remaining portion being the cyclic olefin polymer (COP). The presence of the cyclic olefin copolymer helps improve the heat resistance of the resin composition.

In an implementation of this application, a mass percentage of the cyclic olefin-based polymer in the resin composition ranges from 30% to 60%. In some implementations, the mass percentage of the cyclic olefin-based polymer in the resin composition is 35% to 60%. In some embodiments, the mass percentage of the cyclic olefin-based polymer in the resin composition is, for example, 30%, 35%, 40%, 45%, 50%, 55%, or 60%. Maintaining an appropriate content of the cyclic olefin-based polymer in the resin composition helps ensure basic physicochemical properties required for the resin composition when used as a dielectric material, renders the resin composition more amenable to molding and processing into a desired shape for application in various scenarios, and enables the resin composition to achieve superior insulation and corrosion resistance.

The resin composition in this application can effectively improve toughness of the resin composition and enhance resistance of the resin composition to impact failure by incorporating a small amount of a polyolefin as a modifier for the cyclic olefin-based polymer. The polyolefin is a polymer obtained by polymerizing one or more olefins, may be a polyolefin homopolymer, a polyolefin random copolymer, or a polyolefin block copolymer, and is an unmodified polyolefin. The polyolefin homopolymer is a polymer obtained by polymerizing a single alkene monomer; the polyolefin random copolymer is a polymer obtained by random copolymerization of two or more alkene monomers; and the polyolefin block copolymer is a polymer obtained by block copolymerization of two or more alkene monomers, and has two or more different alkene monomer units arranged orderly. Specifically, the polyolefin may be obtained by polymerizing one or more alkene monomers including, but not limited to, ethylene, propylene, butene, isobutene, pentene, hexene, heptene, octene, nonene, butadiene, pentadiene, hexadiene, heptadiene, and octadiene. The polyolefin homopolymer may be, for example, polyethylene, polypropylene, polybutylene, polybutadiene, or polyhexadiene. The polyolefin block copolymer may be, for example, a propylene-butadiene block copolymer, an ethylene-propylene block copolymer, an ethylene-butadiene block copolymer, or the like. In some implementations of this application, the polyolefin includes a polyolefin block copolymer, and a block copolymerization manner of the polyolefin block copolymer can better ensure high heat resistance while maintaining toughness of the material.

The resin composition of this application can improve interfacial bonding strength, moderately improve the toughness of the resin composition, and effectively enhance the resistance of the resin composition to impact failure by incorporating a small amount of a polyolefin as a modifier for the cyclic olefin-based polymer. The modified polyolefin may be a modified product of the polyolefin. In some examples, the modified polyolefin includes a maleic anhydride-grafted polyolefin.

In some embodiments, the resin composition includes only the polyolefin polymer and does not include the modified polyolefin. In some examples, the resin composition includes only the modified polyolefin and does not include the polyolefin. In some examples, the resin composition includes both the polyolefin and the modified polyolefin. The primary function of the polyolefin is to toughen the resin composition, while the primary function of the modified polyolefin is to improve the interfacial bonding strength. In addition, the two polymers exhibit good compatibility with each other, and the inclusion of both polymers in the resin composition can better improve the mechanical properties of the resin composition.

In an implementation of this application, the mass percentage of the polyolefin and/or the mass percentage of the modified polyolefin in the resin composition range/ranges from 3% to 15%. Incorporation of an appropriate amount of the polyolefin and/or the modified polyolefin can effectively improve the toughness of the resin composition, enhance impact and damage resistance of the resin composition, improve the interfacial bonding strength between inorganic and organic fillers, and enable sufficient incorporation of the cyclic olefin-based polymer and the filler into the resin composition, thereby helping ensure the heat resistance, dielectric properties, and other mechanical properties of the resin composition. In some implementations of this application, the mass percentage of the polyolefin and/or the mass percentage of the modified polyolefin range/ranges from 5% to 10%. In some embodiments of this application, the mass percentage of the polyolefin and/or the mass percentage of the modified polyolefin are/is 3%, 4%, 5%, 5.5%, 6%, 6.5%, 7%, 7.5%, 8%, 8.5%, 9%, 9.5%, 10%, 11%, 12%, 13%, 14%, or 15%.

In some implementations of this application, the mass percentage of the polyolefin in the resin composition ranges from 5% to 15%, for example, 5%, 5.5%, 6%, 6.5%, 7%, 7.5%, 8%, 8.5%, 9%, 9.5%, 10%, 11%, 12%, 13%, 14%, or 15%. The primary function of the polyolefin is to improve the toughness of the resin composition and enhance the impact resistance. Controlling the content of the polyolefin at a high level helps better enhance the impact resistance of the resin composition.

In some implementations of this application, the mass percentage of the modified polyolefin in the resin composition ranges from 1% to 5%, for example, 1%, 2%, 3%, 4%, or 5%. The primary function of the modified polyolefin is to improve the interfacial bonding strength between the components. Controlling the content of the modified polyolefin at a low level helps improve the interfacial bonding strength and ensure enhancement of the impact resistance.

In some embodiments, the resin composition includes both the polyolefin and the modified polyolefin, and the mass percentage of the polyolefin is greater than the mass percentage of the modified polyolefin.

In implementations of this application, a melting temperature of the polyolefin and/or a melting temperature of the modified polyolefin are/is greater than 105°C. The melting temperature is defined as a temperature required for a substance to transition from a high elastic state to a viscous flow state. The polyolefin and the modified polyolefin have a high melting temperature, which helps ensure that the resin composition still maintains high heat resistance while the polyolefin and the modified polyolefin improve the toughness of the resin composition.

In an implementation of this application, the mass percentage of the filler in the resin composition ranges from 35% to 70%. Incorporation of an appropriate amount of the filler improves the mechanical properties such as strength and hardness of the resin composition, and also improves dielectric properties and heat resistance of the resin composition. In some implementations, the mass percentage of the filler in the resin composition is 35%, 40%, 45%, 50%, 55%, 60%, 65%, or 70%.

In an implementation of this application, the filler may include a titanate filler and a non-titanate filler. The mass percentage of the titanate filler ranges from 10% to 40%, and the mass percentage of the non-titanate filler ranges from 0% to 40%. In some embodiments, the filler includes only the titanate filler, and does not include the non-titanate filler. In some examples, the filler includes both the titanate filler and the non-titanate filler.

The titanate filler has a high dielectric constant, and inclusion of the titanate filler in the filler further helps improve the dielectric properties and the impact resistance of the resin composition. In comprehensive consideration with the dielectric properties and temperature drift effect that may be caused by the titanate filler, in an implementation of this application, the mass percentage of the titanate filler is controlled to be 10% to 40%. In some implementations, the mass percentage of the titanate filler is controlled to be 15% to 35%. In some implementations, the mass percentage of the titanate filler is controlled to be 15% to 30%. In some embodiments, the mass percentage of the titanate filler is 10%, 15%, 20%, 25%, 30%, 35%, or 40%. In this application, temperature drift refers to a change in dielectric constant caused by a change in temperature.

In some embodiments of this application, when the filler includes only the titanate filler, the mass percentage of the titanate filler is controlled to be 35% to 40%, for example, 35%, 36%, 37%, 38%, 39%, or 40%.

In implementations of this application, the titanate filler is an oxysalt filler of titanium, and may include one or more of calcium titanate, calcium magnesium titanate, calcium strontium titanate, barium strontium titanate, and barium titanate. The titanate filler has a high dielectric constant, can improve mechanical properties, and exhibit good compatibility with a resin component. Incorporation of the titanate filler into the resin composition helps improve dielectric properties and impact resistance of the resin composition.

In implementations of this application, the titanate filler is in a form of spherical or subspherical particles. The titanate filler being in the form of spherical or subspherical particles helps better reduce a dissipation factor Df of the resin composition, reduce interface defects, improve the mechanical properties of the resin composition, increase a melt flow index of the composition, and facilitate injection molding processing. A higher sphericity is more advantageous. In some embodiments, an average sphericity of the titanate filler is greater than 0.85. The sphericity is a parameter characterizing particle morphology, defined as the ratio of the surface area of a sphere having the same volume as a particle to the surface area of the particle. A particle that is morphologically closer to a sphere has a sphericity closer to 1. In some embodiments of this application, the average sphericity of the titanate filler may be, for example, 0.86, 0.87, 0.88, 0.9, 0.92, 0.93, 0.95, 0.96, 0.98, 0.99, or 1.

In an implementation of this application, the D50 particle size of the titanate filler ranges from 0.5 µm to 100 µm. D50 refers to a particle size at which a cumulative particle size distribution percentage of a sample reaches 50%, and D50 is also referred to as a median diameter or a median particle size. The titanate filler having an appropriate particle size facilitates uniform dispersion of the titanate filler in the resin composition, better exerts performance advantages of the titanate filler, and improves compactness, dielectric properties, mechanical properties, and the like of a molded article obtained by molding the resin composition. In an implementation of this application, the D50 particle size of the titanate filler ranges from 1 µm to 20 µm. In some embodiments, the D50 particle size of the titanate filler may be, for example, 0.5 µm, 1 µm, 5 µm, 10 µm, 15 µm, 20 µm, 25 µm, 30 µm, 35 µm, 40 µm, 45 µm, 50 µm, 55 µm, 60 µm, 65 µm, 70 µm, 75 µm, 80 µm, 85 µm, 90 µm, or 100 µm.

In an implementation, the mass percentage of the non-titanate filler may range from 0% to 40%. Incorporation of the non-titanate filler into the resin composition can exert a synergistic effect with the titanate filler, improving the dielectric properties, and reducing the temperature drift effect of the resin composition, and further reducing a coefficient of thermal expansion of the resin composition. In this way, the resin composition can better have excellent dielectric properties with a low coefficient of thermal expansion. In some implementations of this application, the mass percentage of the non-titanate filler ranges from 10% to 30%. In some embodiments, the mass percentage of the non-titanate filler is 1%, 3%, 4%, 5%, 10%, 12%, 15%, 18%, 20%, 22%, 25%, 28%, 30%, 32%, 35%, 38%, or 40%.

In some implementations of this application, a mass ratio of the titanate filler to the non-titanate filler is greater than or equal to 0.5:1. Controlling the mass ratio helps improve the dielectric properties of the resin composition and better ensures dimensional stability of the molded article of the resin composition. In some embodiments, the mass ratio of the titanate filler to the non-titanate filler is 0.5:1, 0.6:1, 0.8:1, 1:1, 1.5:1, 2:1, 2.5:1, or 3:1. In some implementations, the mass ratio of the titanate filler to the non-titanate filler is greater than or equal to 1:1.

In implementations of this application, the non-titanate filler includes a metal oxide or a non-metal oxide. The metal oxide or the non-metal oxide may include, but is not limited to, hafnium dioxide, titanium oxide, lead oxide, tantalum oxide, and the like. In some embodiments, the non-titanate filler includes one or more of hafnium dioxide, titanium oxide, lead oxide, and tantalum oxide. The metal oxides each have a high dielectric constant and structural stability. When the metal oxide is compounded with the titanate filler and incorporated into the resin composition, the dielectric properties and dimensional stability of the resin composition can be effectively improved.

In an implementation of this application, the dielectric constant of the non-titanium filler is greater than 20. Selection of a non-titanate filler having a high dielectric constant helps improve the dielectric properties of the resin composition. In some embodiments, the dielectric constant of the non-titanate filler is greater than or equal to 30. In some embodiments, the dielectric constant of the non-titanate filler is greater than or equal to 40. In some embodiments, the dielectric constant of the non-titanate filler is greater than or equal to 50. In some examples, the dielectric constant of the non-titanate filler is greater than or equal to 55. In some embodiments, the dielectric constant of the non-titanate filler is greater than or equal to 60. In some embodiments, the dielectric constant of the non-titanate filler is greater than or equal to 70. In some embodiments, the dielectric constant of the non-titanate filler is greater than or equal to 80.

In implementations of this application, the non-titanate filler is in the form of spherical or subspherical particles. The non-titanate filler being in the form of spherical or subspherical particles helps better reduce the dissipation factor Df of the resin composition, reduce interface defects, and improve the mechanical properties of the resin composition. In some embodiments, the average sphericity of the non-titanate filler is greater than 0.85. In some embodiments of this application, the average sphericity of the non-titanate filler may be, for example, 0.86, 0.87, 0.88, 0.9, 0.92, 0.93, 0.95, 0.96, 0.98, 0.99, or 1.

In an implementation of this application, the D50 particle size of the non-titanate filler ranges from 0.1 µm to 10 µm. The non-titanate filler having an appropriate particle size facilitates uniform dispersion of the titanate filler in the resin composition, better exerts the performance advantages of the non-titanate filler, and improves the compactness, dielectric properties, mechanical properties, and the like of the molded article obtained by molding the resin composition. In some embodiments, the D50 particle size of the non-titanate filler may be, for example, 0.1 µm, 0.2 µm, 0.5 µm, 1 µm, 2 µm, 3 µm, 4 µm, or 5 µm.

To improve some properties of the resin composition, an additive may also be incorporated based on an actual requirement. In some implementations of this application, the resin composition further includes an additive, and a mass percentage of the additive in the resin composition is less than or equal to 2%. The additive may include one or more of an antioxidant, a flame retardant, and a lubricant. The antioxidant can improve oxidation resistance of the resin composition, the flame retardant can improve flame retardancy of the resin composition, and the lubricant can improve lubricity of the resin composition.

In an implementation of this application, a dielectric constant Dk of the resin composition is greater than or equal to 4.5, and the dissipation factor Df at 10 GHz ranges from 0.0004 to 0.001. In embodiments of this application, the specific component design enables the resin composition to have a high dielectric constant and an extremely low dissipation factor at a high frequency of 10 GHz. When the resin composition is applied in the manufacture of communication components, signal transmission efficiency can be effectively improved, and loss can be reduced, thereby better meeting the requirements for high-quality and high-efficiency signal transmission at high frequencies and the demand for miniaturization of the communication components. A higher dielectric constant is more advantageous for miniaturization design of an antenna. In some embodiments, the dielectric constant Dk of the resin composition is, for example, 4.5, 4.6, 4.8, 5.0, 5.2, 5.5, 6.0, 6.2, 6.5, 7.0, or 7.1. In some embodiments, the dielectric constant Dk of the resin composition is greater than or equal to 5.0. In some embodiments, the dissipation factor Df of the resin composition at 10 GHz is 0.0004, 0.0005, 0.0006, 0.0007, 0.0008, 0.0009, or 0.001. In some embodiments, the dissipation factor Df of the resin composition at 10 GHz is 0.0004 to 0.0008. The dielectric constant and dissipation factor of the resin composition may be measured by using a network analyzer in conjunction with a 10 GHz fixture.

In an implementation of this application, a heat deflection temperature of the resin composition is greater than or equal to 155°C. The heat deflection temperature (Heat deflection temperature, HDT) refers to a temperature at which a resin material undergoes deformation under an external load, and the heat deflection temperature is an important indicator for evaluating the heat resistance of the resin composition. The resin composition according to this embodiment of this application has a high heat deflection temperature, indicating that the resin composition has excellent heat resistance, can better meet requirements in high-temperature application scenarios, and improve service reliability of the communication component. In some embodiments, the heat deflection temperature of the resin composition is, for example, 155°C, 160°C, or 165°C. The heat deflection temperature can be tested by using an HDT/Vicat tester according to a standard ISO 75-1: Plastics-Determination of temperature of deflection under load.

In an implementation of this application, an Izod notched impact strength of the resin composition is greater than 5 kJ/m². The Izod notched impact strength represents a capability of a material to resist impact, and may be tested by using the Izod notched impact tester according to a standard ISO 180: Plastics-Determination of Izod impact strength. In some embodiments of this application, the Izod notched impact strength of the resin composition is greater than or equal to 5.3 kJ/m². In some embodiments of this application, the Izod notched impact strength of the resin composition is greater than or equal to 6 kJ/m². In some embodiments of this application, the Izod notched impact strength of the resin composition is greater than or equal to 6.5 kJ/m². In some embodiments of this application, the Izod notched impact strength of the resin composition is greater than 7 kJ/m².

The resin composition according to this embodiment of this application has a high dielectric constant, a low dissipation factor, and excellent heat resistance and impact resistance. When used as a dielectric material in the communication field, the resin composition can improve signal transmission efficiency, and satisfy requirements for mechanical properties and heat resistance, thereby better meeting application requirements of high-frequency communication and miniaturized communication components, and promoting development of high-frequency operation and miniaturization of communication components such as an antenna.

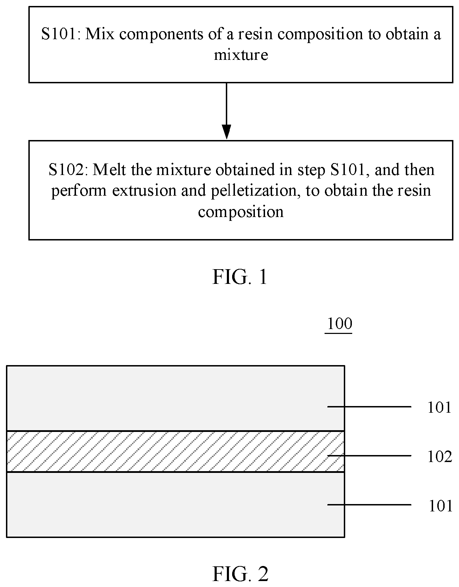

With reference to FIG. 1, an embodiment of this application further provides a preparation method for the resin composition, including:
S101: Mix components of the resin composition to obtain a mixture.

A manner of mixing a cyclic olefin-based polymer, a polyolefin and/or a modified polyolefin, and a filler is not limited, which may be direct mixing in an extrusion device, for example, mixing in a twin-screw extruder. Specifically, for example, the resin components, namely, the cyclic olefin-based polymer, the polyolefin, and/or the modified polyolefin, are mixed and then fed into a main feeding system of the twin-screw extruder, the filler is fed to a side feeding system of the twin-screw extruder, and a feed flow rate is set based on a ratio of the resin components to the filler.

When the components of the resin composition further include an additive, the additive may be fed into the main feeding system of the twin-screw extruder together with the resin components.

S102: Melt the mixture obtained in step S101, and then perform extrusion and pelletization, to obtain the resin composition.

A melting temperature is determined based on a type of the resin component. In the extrusion and pelletization process, an extrusion temperature of the twin-screw extruder may range from 220°C to 290°C, for example, 220°C, 230°C, 240°C, 250°C, 260°C, 270°C, 280°C, or 290°C; a rotation speed of a screw may range from 400 rpm to 600 rpm, for example, 400 rpm, 500 rpm, or 600 rpm; and a length-to-diameter ratio of the screw may be 40:1. The resin composition obtained after pelletization is a resin composition pellet.

The preparation method according to this embodiment of this application has a simple process, which facilitates mass production.

An embodiment of this application further provides a molded article. The molded article includes a molded article of the resin composition according to embodiments of this application. The molded article may be designed into various regular or irregular shapes and specific dimensions according to practical application requirements. The molded article is in a solid state. Specifically, the molded article may be obtained by injection molding, calendering, or extrusion molding.

With reference to FIG. 2, an embodiment of this application further provides an electronic component 100. The electronic component 100 includes a molded article of the resin composition according to embodiments of this application. In some embodiments, the electronic component includes a function layer 102 and an insulating dielectric layer 101 disposed on opposite sides of the function layer 102. The insulating dielectric layer 101 includes the molded article of the resin composition according to embodiments of this application. The electronic component 100 may be any electronic component requiring an application of a dielectric material, for example, a communication component, a capacitor, or the like. It should be noted that FIG. 2 merely schematically shows a possible presence form of the insulating dielectric layer 101 of the electronic component 100, to demonstrate the presence form of the molded article of the resin composition. This structural diagram does not constitute a limitation on a specific structure of the electronic component 100.

In some embodiments, the electronic component 100 is a communication component. The communication component may be various communication components requiring the application of a dielectric material, including an antenna, a microwave device, a radio frequency device, a metal stripline assembly, and the like. The molded article of the resin composition may be specifically used as a dielectric substrate or a dielectric frame, or a dielectric layer. The communication component uses the resin composition according to embodiments of this application as a dielectric material, which can effectively improve signal transmission efficiency and also helps improve thermal stability and impact resistance, thereby enhancing product reliability.

In some embodiments, the resin composition is used in a microwave device in an antenna, for example, may be used in a phase control apparatus of the microwave device. The microwave device may be a microwave modulator, a microwave amplifier, a microwave filter, a microwave switch, a microwave mixer, or the like.

In some embodiments, the resin composition is used in a radio frequency device. The radio frequency device may be a radio frequency amplifier, a radio frequency switch, a radio frequency filter, a radio frequency mixer, a radio frequency power amplifier, a combiner, a phase shifter, or the like.

In some embodiments, the resin composition is used in a metal stripline assembly in an antenna, for example, may be used to form an isolation apparatus between metal striplines.

An embodiment of this application further provides a communication system. The communication system includes the communication component according to embodiments of this application. The communication system using the foregoing communication component exhibits enhanced signal transmission efficiency, and better thermal stability and impact resistance.

Embodiments of this application are further described below by using a plurality of embodiments.

### Embodiment 1 to Embodiment 7

The resin components, namely, a cyclic olefin-based polymer, a polyolefin and/or a modified polyolefin, and an additive, are mixed and then fed into a main feeding system of a twin-screw extruder, and the filler is fed into a side feeding system of the twin-screw extruder. After melting, the mixture is subjected to extrusion and pelletization to obtain resin composition pellets. The compounding ratios of the cyclic olefin-based polymer, the polyolefin and/or modified polyolefin, the fillers and the additives are specified in Table 1.

### Comparative embodiment 1 to Comparative embodiment 4

Resin composition pellets were prepared by using the same preparation method as in Embodiment 1, with the compounding ratios specified in Table 1.

In Table 1, the spherical or subspherical calcium titanate, subspherical titanium oxide and silica are all classified as fillers.

The resin compositions and molded articles obtained from Embodiment 1 to Embodiment 7 and Comparative embodiment 1 to Comparative embodiment 4 were subjected to tests for heat deflection temperature (HDT), Izod notched impact strength, dielectric constant and dissipation factor, with the test results specified in Table 1.

Heat deflection temperature (HDT): Tested using an HDT/Vicat tester in accordance with standard ISO 75-1: Plastics - Determination of temperature of deflection under load.

Izod notched impact strength: Tested using an Izod notched impact tester in accordance with standard ISO 180: Plastics - Determination of Izod impact strength.

Dielectric constant and dissipation factor test: Tested using a network analyzer equipped with a 10 GHz test fixture.

**Table 1**

| Raw Material Compone nt | Embo dimen t 1 | Embo dimen t 2 | Embo dimen t 3 | Embo dimen t 4 | Embo dimen t 5 | Embo dimen t 6 | Embo dimen t 7 | Comp arativ e embo dimen t 1 | Comp arativ e embo dimen t 2 | Comp arativ e embo dimen t 3 | Comp arativ e embo dimen t 4 |
|---|---|---|---|---|---|---|---|---|---|---|---|
| Cyclic olefin copolyme r (HDT 165°C) | 33.8 | 36.8 | 31.8 | 39.8 | 39.8 | 21.8 | 20.8 | 47.8 | 28.8 | 36.8 | 33.8 |
| Cyclic olefin polymer (HDT 155°C) | | | 20 | | | 10 | 19 | | | | |
| Spherical or subspheri cal calcium titanate | 26 | 27 | 40 | 35 | 15 | 34 | 23 | 26 | 26 | 7 | 26 |
| Subspheri cal titanium oxide | 26 | 25 | | 15 | 35 | 27 | 25 | 26 | 26 | 45 | |
| Silicon dioxide Dk<20 | | | | | | | | | | | 26 |
| Maleic anhydride -grafted polyolefi n | | 1 | 3 | 2 | 2 | 1 | 5 | | | 1 | |
| Polyolefi n block copolymer | 14 | 10 | 5 | 8 | 8 | 6 | 7 | | 19 | 10 | 14 |
| Antioxida nt | 0.2 | 0.2 | 0.2 | 0.2 | 0.2 | 0.2 | 0.2 | 0.2 | 0.2 | 0.2 | 0.2 |
| HDT (°C) | 165.4 | 156.8 | 155.4 | 160.4 | 160.1 | 156.8 | 156.5 | 170.9 5 | 148.3 | 160.4 | 143.6 |
| Izod notched impact strength (kJ/m²) | 6.86 | 7.08 | 5.3 | 6.03 | 6.12 | 5.14 | 6.02 | 1.9 | 7.18 | 3.68 | 6.98 |
| Dielectric constant Dk | 5.3 | 5.5 | 5.01 | 6.4 | 5.0 | 6.3 | 5.2 | 5.5 | 5.3 | 4.9 | 3.1 |
| Dissipati on factor Df | 0.000 7 | 0.000 57 | 0.000 7 | 0.000 8 | 0.000 5 | 0.000 7 | 0.000 6 | 0.000 7 | 0.000 8 | 0.001 6 | 0.000 6 |

As demonstrated by the test results set forth in Table 1, the resin composition obtained in Embodiment 1 to Embodiment 7 of this application, prepared by compounding the cyclic olefin-based polymer, the polyolefin and/or the modified polyolefin as modifiers, together with a specific type of filler at an appropriate compounding ratio, may have a high dielectric constant of not less than 4.5, a low dissipation factor of not more than 0.001, a high heat deflection temperature of not less than 155°C and an Izod notched impact strength of not less than 5.0 kJ/m².

The difference between Embodiment 1 and Comparative embodiment 1 lies in that no olefin block copolymer is incorporated as a modifier in Comparative Embodiment 1. It can be learned from the results of Embodiment 1 and Comparative embodiment 1 that, by compounding the polyolefin block copolymer as a modifier with the cyclic olefin-based polymer matrix, the resin composition of Embodiment 1 may achieve a significant enhancement in Izod notched impact strength.

The difference between Embodiment 1 and Comparative embodiment 2 lies in that the mass percentage of the olefin block copolymer incorporated as a modifier in Comparative embodiment 2 is greater than 15% by mass. It can be learned from the results of Embodiment 1 and Comparative embodiment 2, when the fillers are used at the same total mass percentages to ensure consistent dielectric properties, the incorporation of an excessive amount of the polyolefin block copolymer as a modifier results in the heat deflection temperature of the resin composition failing to meet the high heat resistance requirements.

The difference between Embodiment 2 and Comparative embodiment 3 lies in that an excessively low amount of calcium titanate filler and an excessively high amount of titanium oxide filler are incorporated in Comparative embodiment 3. It can be learned from the results of Embodiment 2 and Comparative embodiment 3 that, even with the same total mass percentages of fillers, an excessively low incorporation of calcium titanate filler coupled with an excessively high incorporation of titanium oxide filler does not help improve the dielectric properties and impact resistance. In contrast, the resin composition obtained in Embodiment 2, which is prepared by compounding an appropriate amount of the calcium titanate filler and titanium oxide filler, may achieve a significant improvement in dielectric properties and impact resistance.

It can be learned from a comparison between Embodiment 1 and Comparative embodiment 4 that, in Embodiment 1 of this application, a relatively high dielectric constant can be obtained by compounding the titanium oxide filler with a Dk of greater than 50 with the calcium titanate filler, whereas the non-titanium titanate filler incorporated in Comparative embodiment 4 is silicon dioxide with a Dk of less than 20 in an equal mass, resulting in the Dk of the resin composition being far less than 4.5.

It can be learned from a comparison between Embodiment 4 and Embodiment 5 that, for the fillers with the same total mass proportion, the proportion of the calcium titanate filler is greater than that of the titanium oxide filler, which helps improve the dielectric constant of the resin composition.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate the following three cases: Only A exists, both A and B exist, and only B exists, where A and B may be singular or plural. The character "/" generally indicates an "or" relationship between the associated objects.

In this application, at least one means one or more, and a plurality of means two or more. "At least one of the following items (pieces)" or a similar expression thereof means any combination of these items, including any combination of singular items (pieces) or plural items (pieces). For example, "at least one of a, b, or c", or "at least one of a, b, and c" may indicate: a, b, c, a-b (namely, a and b), a-c, b-c, or a-b-c, where a, b, and c may be singular or plural.

In this application, "-" indicates a range value, including endpoint values at two ends. For example, a value of a may be 0.5-15. It indicates that the value of a may range from 0.5 to 15, and endpoint values 0.5 and 15 are included.

It should be understood that sequence numbers of the foregoing processes do not mean an execution sequence in various embodiments of this application. A part or all of the steps may be performed in parallel or in sequence. The execution sequence of the processes should be determined based on functions and internal logic of the processes, and should not be construed as any limitation on the implementation processes of embodiments of this application.

## Claims

1. A resin composition, wherein the resin composition comprises the following components in mass percentages: 30% to 60% of cyclic olefin-based polymer, 3% to 15% of polyolefin and/or modified polyolefin, and 35% to 70% of filler; and
the filler comprises a titanate filler and a non-titanate filler, a mass percentage of the titanate filler ranges from 10% to 40%, a mass percentage of the non-titanate filler ranges from 0% to 40%, and a dielectric constant of the non-titanate filler is greater than 20.

2. The resin composition according to claim 1, wherein a heat deflection temperature of at least a portion of the cyclic olefin-based polymer is greater than or equal to 140°C.

3. The resin composition according to claim 1, wherein a heat deflection temperature of at least a portion of the cyclic olefin-based polymer is greater than or equal to 150°C.

4. The resin composition according to any one of claims 1 to 3, wherein the heat deflection temperature of the at least a portion of the cyclic olefin-based polymer is greater than or equal to 160°C.

5. The resin composition according to any one of claims 1 to 4, wherein the at least a portion of the cyclic olefin-based polymer is a cyclic olefin copolymer.

6. The resin composition according to any one of claims 1 to 5, wherein the mass percentage of the polyolefin and/or the mass percentage of the modified polyolefin range/ranges from 5% to 10%.

7. The resin composition according to any one of claims 1 to 6, wherein a melting temperature of the polyolefin and/or a melting temperature of the modified polyolefin are/is greater than 105°C.

8. The resin composition according to any one of claims 1 to 7, wherein the polyolefin comprises a polyolefin block copolymer.

9. The resin composition according to any one of claims 1 to 8, wherein the modified polyolefin comprises maleic anhydride-grafted polyolefin.

10. The resin composition according to any one of claims 1 to 9, wherein a mass ratio of the titanate filler to the non-titanate filler is greater than or equal to 0.5:1.

11. The resin composition according to any one of claims 1 to 10, wherein the titanate filler comprises one or more of calcium titanate, calcium magnesium titanate, calcium strontium titanate, barium strontium titanate, and barium titanate.

12. The resin composition according to any one of claims 1 to 11, wherein the titanate filler is in a form of spherical or subspherical particles, with an average sphericity of greater than 0.85.

13. The resin composition according to any one of claims 1 to 12, wherein a D50 particle size of the titanate filler ranges from 0.5 µm to 100 µm.

14. The resin composition according to any one of claims 1 to 13, wherein the non-titanate filler comprises a metal oxide or a non-metal oxide, and the metal oxide or the non-metal oxide comprises titanium oxide.

15. The resin composition according to any one of claims 1 to 14, wherein the dielectric constant of the non-titanate filler is greater than 50, and the non-titanate filler is in a form of spherical or subspherical particles, with an average sphericity of greater than 0.85.

16. The resin composition according to any one of claims 1 to 15, wherein a D50 particle size of the non-titanate filler ranges from 0.1 µm to 10 µm.

17. The resin composition according to any one of claims 1 to 16, wherein the mass percentage of the non-titanate filler ranges from 10% to 30%.

18. The resin composition according to any one of claims 1 to 17, wherein the resin composition further comprises an additive, and a mass percentage of the additive is less than or equal to 2%.

19. The resin composition according to claim 18, wherein the additive comprises one or more of an antioxidant, a flame retardant, and a lubricant.

20. The resin composition according to any one of claims 1 to 19, wherein a dielectric constant Dk of the resin composition is greater than or equal to 4.5, and a dissipation factor Df at 10 GHz ranges from 0.0004 to 0.001.

21. The resin composition according to any one of claims 1 to 20, wherein a heat deflection temperature of the resin composition is greater than or equal to 155°C.

22. The resin composition according to any one of claims 1 to 21, wherein a notched Izod impact strength of the resin composition is greater than 5 kJ/m².

23. A preparation method for the resin composition according to any one of claims 1 to 22, comprising:
mixing the components of the resin composition to obtain a mixture; and
melting the mixture, and then performing extrusion and pelletization, to obtain the resin composition.

24. A molded article, comprising a molded article of the resin composition according to any one of claims 1 to 22.

25. An electronic component, wherein the electronic component comprises the molded article of the resin composition according to any one of claims 1 to 22.

26. The electronic component according to claim 25, wherein the electronic component comprises a communication component, or a capacitor.

27. The electronic component according to claim 26, wherein the communication component comprises an antenna, a microwave device, a radio frequency device, or a metal stripline assembly.

28. A communication system, wherein the communication system comprises a communication component, and the communication component comprises the molded article of the resin composition according to any one of claims 1 to 22.
